# EUROPEAN PATENT SPECIFICATION

(11) **EP 3 381 569 B1**
(45) Date of publication and mention of the grant of the patent: **15.05.2024**
(21) Application number: 16868330.8
(22) Date of filing: 01.11.2016
(51) Int. Cl.: B05C 1/02, B05D 1/28, H05K 3/10, B05C 5/02

(54) **APPLICATION UNIT, APPLICATION APPARATUS, AND METHOD FOR MANUFACTURING OBJECT TO WHICH MATEREAL IS APPLIED**
BESCHICHTUNGSEINHEIT, BESCHICHTUNGSVORRICHTUNG, VERFAHREN ZUR HERSTELLUNG EINES ZU BESCHICHTENDEN OBJEKTS UND VERFAHREN ZUR HERSTELLUNG VON SUBSTRAT
UNITÉ DE REVÊTEMENT, DISPOSITIF DE REVÊTEMENT, PROCÉDÉ DE PRODUCTION D'UN OBJET À REVÊTIR ET PROCÉDÉ DE PRODUCTION D'UN SUBSTRAT

(30) Priority: 25.11.2015 JP 2015229631; 25.11.2015 JP 2015229668
(43) Date of publication of application: 03.10.2018
(73) Proprietor: NTN Corporation, Osaka-shi, Osaka 550-0003 (JP)
(72) Inventor: YAMANAKA, Akihiro, Iwata-shi Shizuoka 4388510 (JP)
(74) Representative: Bockhorni & Brüntjen Partnerschaft Patentanwälte mbB
(86) International application number: PCT/JP2016/082392
(87) International publication number: WO 2017/090381

(56) References cited:
- JP-A- 2006 276 188
- JP-A- 2010 062 385
- JP-A- 2010 062 385
- JP-A- 2015 112 576
- US-A- 3 334 354
- US-A1- 2005 042 381

## Description

### TECHNICAL FIELD

The present invention relates to an application unit for applying a liquid material and an application apparatus for which the application unit is used. More specifically, the invention relates to an application unit for applying a material to a target object using an application needle to thereby draw an electrically conductive pattern or repair open defects in an electrically conductive pattern, and to an application apparatus for which the application unit is used. The present invention further relates to a method for manufacturing an object to which a material is applied by such an application unit or application apparatus.

### BACKGROUND ART

In recent years, the printed electronics technology for drawing and thereby forming a minute circuit such as RFID (Radio Frequency Identification) tag by a printing (also referred to hereinafter as application) system has been developed rapidly. The printing system, the inkjet system, and the like are common systems for forming minute circuit patterns and electrode patterns. A system using an application needle is also capable of finely applying materials of a wide range of viscosities. In this respect, the system using an application needle has recently been of interest.

As a method for finely applying a liquid material using an application needle, a method using an application unit disclosed for example in Japanese Patent No. 4802027 (Patent Document 1) has been proposed.

Such an application unit aims to repair defects in a fine pattern, and can finely apply materials of a wide range of viscosities. In applying a material, an application needle is caused to project from a through hole formed in the bottom of an application material container in which the material to be applied is held. The application material adheres to the head of the application needle, and this head is brought into contact with a target object to be subjected to material application (referred to hereinafter as "target object"). In this way, transfer application of the material (referred to hereinafter as material application) is performed.
US 3,334,354 A discloses an application unit according the preamble of claim 1.
US 2005/042381 A1 and JP 2010062385 A disclose alternative application units.

### CITATION LIST

### PATENT DOCUMENT

PTD 1: Japanese Patent No. 4802027

### SUMMARY OF INVENTION

### TECHNICAL PROBLEM

Repetition of material application, however, results in the following problem.

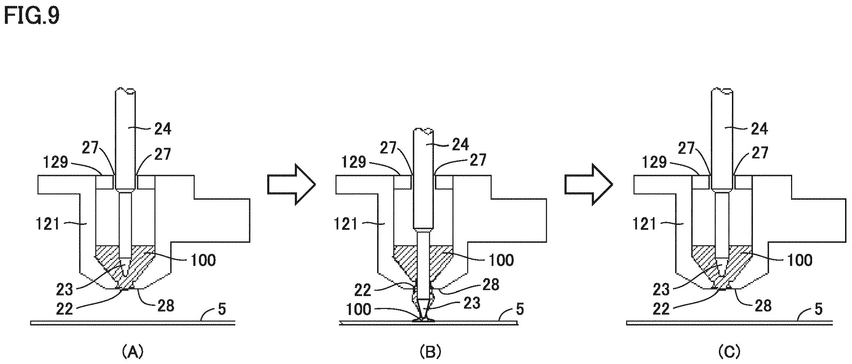

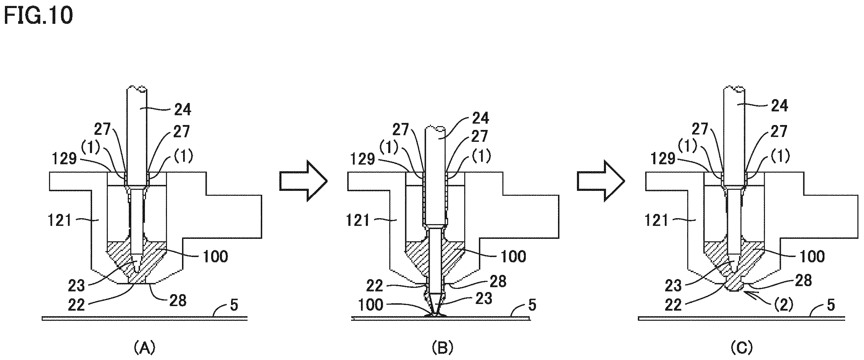

Figs. 9 and 10 each show an example of the state of an application unit repeating material application. Fig. 9 shows a case where the application unit operates normally because the number of times material application has been repeated is small, and Fig. 10 shows a case where the normal operation of the application unit fails because material application has been repeated many times.

Fig. 9 (A) shows a material application standby state. Fig. 9 (B) shows an application-needle-protruding state after transition from the state in Fig. 9 (A). Fig. 9(C) shows a material application standby state after transition from the state in Fig. 9(B).

As shown in Fig. 9 (A) to Fig. 9 (C), an application material 100 is contained in an application material container 121.

A first hole 22 is formed in a bottom 28 of application material container 121, and a second hole 27 is formed in an upper lid 129. An application needle 24 is configured to be movable along a line passing through first hole 22 and second hole 27.

As shown in Fig. 9 (A) to Fig. 9 (C), during the normal operation, there is no pool of the application material as described below.

Fig. 10 (A) shows a material application standby state. Fig. 10 (B) shows an application-needle-protruding state after transition from the state in Fig. 10 (A). Fig. 10 (C) shows a material application standby state after transition from the state in Fig. 10 (B).

As shown in Fig. 10 (C), a pool of the application material (indicated by (2)) is generated in first hole 22. Because of this, the amount of application material 100 adhering to a head 23 of application material 24 varies, resulting in a problem that the amount of application material 100 applied to a target object is not uniform. Such a pool of an application material is generated for the following reason.

As shown in Fig. 10 (A) to Fig. 10 (C), while the material application is repeated multiple times, application material 100 adheres to an upper part of application needle 24 as indicated by (1), and also enters a gap between the upper part of application needle 24 and the wall of second hole 27 to thereby hermetically seal upper lid 129 of application material container 121. Accordingly, when the material is applied, a large-diameter shaft of application needle 24 inserted into application material container 121 pressurizes the air in application material container 121 to push the application material out of first hole 22 of application material container 121, resulting in a pool of the application material. This problem is particularly noticeable when the material is an electrically conductive high-viscosity material containing metal powder.

In order to draw a fine circuit such as RFID tag, it is necessary to be able to apply a high-viscosity metal material stably for a long rime. In the case of the conventional system, however, a high-viscosity metal conductive material is difficult to apply stably for a long time.

A principal object of the present invention is to solve the above conventional problem and provide an application unit capable of applying a material stably for a long time and an application apparatus for which the application unit is used, and a method for manufacturing an object to which a material is applied by means of such an application unit or application apparatus.

### SOLUTION TO PROBLEM

An application unit of the present invention includes a container to contain an application material, and an application needle to apply to a target surface the application material contained in the container. A first hole is formed in a bottom of the container, and a second hole is formed in an upper lid of the container. The application needle is configured to be movable along a line passing through the first and second holes. The application needle comprises an upper part having a large diameter shaft arranged to be inserted into the application material container. A fine gap is formed between the wall of the second hole and the application needle to enable the application needle to move up and down. A third hole is formed in a part of the container for allowing air to be discharged through the third hole when the large-diameter shaft of the application needle is inserted in the application material container, and allowing the air in application material container not to be pressurized when the application material adheres to an upper portion of application needle and also enters the fine gap between the upper portion of application needle and the wall of second hole and thereby hermetically seals upper lid of application material container.

Preferably, the third hole is formed in the upper lid.

The application apparatus of the present invention applies a material to a target surface by means of the application unit.

A method for manufacturing an object to which a material is applied according to the present invention uses any of the application unit and the application apparatus.

### ADVANTAGEOUS EFFECTS OF INVENTION

According to the present invention, the application material can be applied stably for a long time.

### BRIEF DESCRIPTION OF DRAWINGS

Fig. 1 is a schematic perspective view of an application apparatus according to an embodiment of the present invention.
Fig. 2 (A) is a front view of an application unit, and Fig. 2 (B) is a side view of the application unit.
Fig. 3 (A) and Fig. 3 (B) are each a developed view of a flange portion including a cam surface as seen laterally.
Fig. 4 (A) and Fig. 4 (B) show an application material container and an application needle that are included in the application unit shown in Fig. 1 in Embodiment 1.
Fig. 5 is an enlarged view of a region 350 shown in Fig. 4 (A).
Fig. 6 (A) to Fig. 6 (C) show an application material container and an application needle that are included in the application unit shown in Fig. 1 in a configuration not in accordance with the invention.
Fig. 7 is an enlarged view of a region R shown in Fig. 6 (A).
Fig. 8 (A) is an enlarged view of a C chamfer 81 in Fig. 7, and Fig. 8 (B) is an enlarged view of a C chamfer 82 in Fig. 7.
Fig. 9 (A) to Fig. 9 (C) show examples of the state of the application unit having repeated material application a small number of times.
Fig. 10 (A) to Fig. 10 (C) show examples of the state of the application unit having repeated material application a large number of times.

### DESCRIPTION OF EMBODIMENTS

In the following, embodiments of the present invention are described with reference to the drawings. In the description below, the same parts are denoted by the same reference characters. They are named identically and function identically. A detailed description thereof will therefore not be repeated.

### [Embodiment 1]

### [Overall Configuration of Application Apparatus]

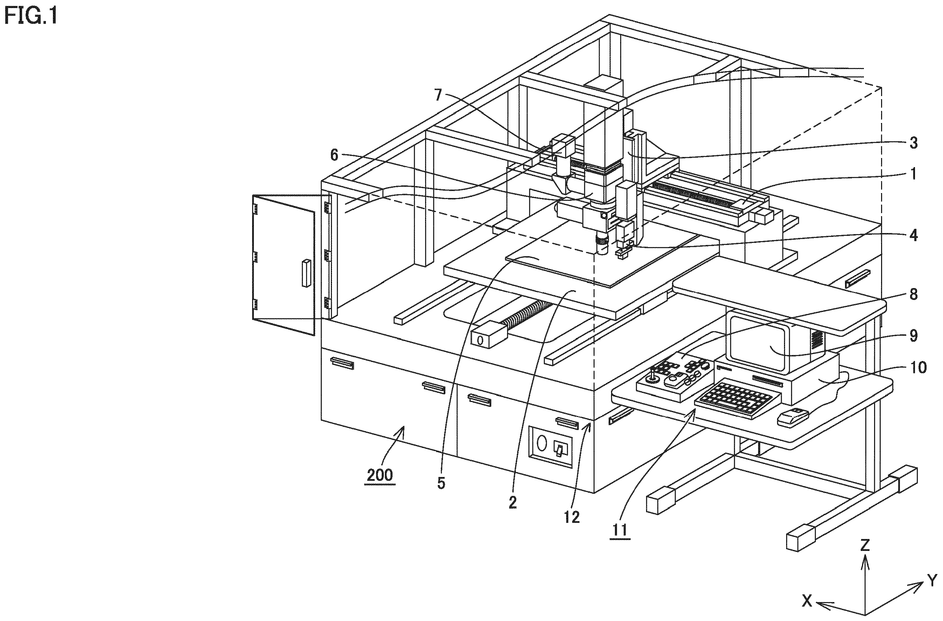

Fig. 1 is a schematic perspective view of an application apparatus 200 according to an embodiment of the present invention. Referring to Fig. 1, application apparatus 200 in the embodiment of the present invention includes a base 12 placed on a floor, an X-axis table 1, a Y-axis table 2, a Z-axis table 3, an application unit 4, an observation optical system 6, a CCD camera 7 connected to observation optical system 6, and a control unit 11.

Above the top surface of base 12, Y-axis table 2 configured to be movable in the Y-axis direction in Fig. 1 is placed. Specifically, a guide is placed on the lower surface of Y-axis table 2. The guide is slidably connected to a guide rail placed on the top surface of base 12. A ball screw is connected to the lower surface of Y-axis table 2. The ball screw can be operated by a drive member such as motor to cause Y-axis table 2 to move along the guide rail (in the Y-axis direction). The upper surface of Y-axis table 2 is a mount surface on which a substrate 5, which is a material on which a material is to be applied, is mounted.

A gate-shaped structure is placed in the X-axis direction to extend over and across the guide rail for Y-axis table 2. On this structure, X-axis table 1 movable in the X-axis direction is mounted. X-axis table 1 is movable in the X-axis direction by means of a ball screw, for example.

On a movable member of X-axis table 1, Z-axis table 3 is mounted. On Z-axis table 3, application unit 4 and observation optical system 6 are mounted. Application unit 4 and observation optical system 6 are movable in the X-axis direction together with Z-axis table 3. Application unit 4 is disposed to apply a material to a target surface (top surface) of substrate 5 by means of an application needle mounted on application unit 4. Observation optical system 6 is provided to observe the position on target substrate 5 to which the material is to be applied. CCD camera 7 of observation optical system 6 converts an observed image into an electrical signal. Z-axis table 3 supports these application unit 4 and observation optical system 6 in such a manner that they are movable in the Z-axis direction.

Control unit 11 includes an operation panel 8, a monitor 9, and a control computer 10. Control unit 11 controls X-axis table 1, Y-axis table 2, Z-axis table 3, application unit 4, and observation optical system 6. Operation panel 8 is used to input commands to control computer 10. Monitor 9 displays image data converted by CCD camera 7 of observation optical system 6 and displays data that is output from control computer 10.

When a circuit pattern is to be newly formed on substrate 5, or when a defect in a circuit pattern formed on substrate 5 is to be repaired, a position where a circuit pattern is to be drawn on target substrate 5 is moved to immediately below observation optical system 6 by X-axis table 1 and Y-axis table 2, a drawing start position is observed and confirmed by observation optical system 6, and the drawing start position is determined. Then, with respect to the determined drawing start position, a circuit pattern is drawn. Substrate 5 is moved by X-axis table 1 and Y-axis table 2 successively from the drawing start position so that the drawing position where the circuit pattern is to be drawn is located immediately under application unit 4. When substrate 5 is moved to the drawing position and stopped, application unit 4 is driven to apply the material. This can be repeated successively to draw the circuit pattern.

The relation between the lowermost end position of application needle 24 to which application needle 24 is lowered and the focus position of observation optical system 6 is stored in advance. When a circuit pattern is to be drawn, the position where the image is focused by observation optical system 6 is used as a reference in the Z-axis direction, and the position in the Z-axis direction is moved by the Z-axis table to the height where application needle 24 touches substrate 5. Then, the material is applied. If the area of a circuit pattern to be drawn is large and the height of the target substrate surface of substrate 5 to which the material is applied varies to a large extent during drawing, the focus position is confirmed during the drawing as required to correct the position in the Z-axis direction and then the material is applied. The adjustment of the focus position at this time may be done automatically by image processing, or the position of the height of the surface of target substrate 5 may be detected continuously by means of a laser sensor or the like and corrected real time.

A substrate on which a pattern is formed can be obtained through a method for manufacturing a substrate including the step of newly forming a circuit pattern on the substrate by the method for drawing a circuit pattern on substrate 5 as described above.

Moreover, a method for manufacturing a substrate including the step of repairing a defect in a circuit pattern formed already on the substrate by any of other systems such as printing system and ink-jet system according to the method for drawing a circuit pattern on substrate 5 as described above can be used to obtain the substrate without defects in the pattern.

### Configuration of Application Unit

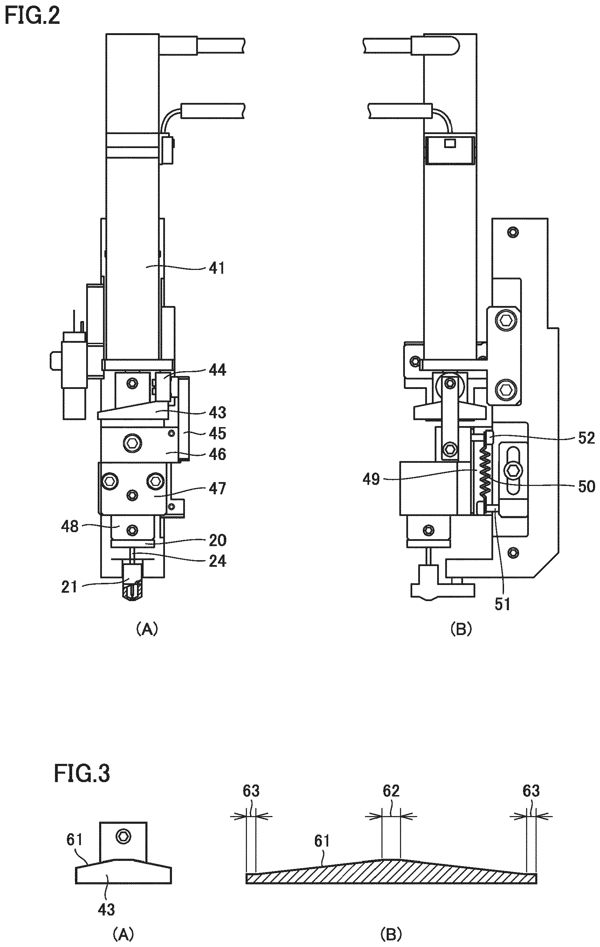

Aforementioned application unit 4 is described in more detail with reference to Figs. 2 and 3. Application unit 4 fixed to Z-axis table 3 shown in Fig. 1 mainly includes a servo motor 41, a cam 43, a bearing 44, a cam coupling plate 45, a movable portion 46, an application needle holder 20, an application needle 24 held by application needle holder 20, and an application material container 21. Servo motor 41 is placed so that its rotational shaft extends in the direction along the Z-axis direction shown in Fig. 1. Cam 43 is connected to the rotational shaft of servo motor 41. Cam 43 is rotatable about the rotational shaft of servo motor 41.

Cam 43 includes a central portion connected to the rotational shaft of servo motor 41, and a flange portion connected to one end of the central portion. As shown in Fig. 3 (A), the upper surface of the flange portion (the surface facing servo motor 41) is a cam surface 61. Cam surface 61 is formed in an annular shape along the outer periphery of the central portion, and is formed to slope so that the distance from the bottom surface of the flange portion to cam surface 61 varies. Specifically, as shown in Fig. 3 (B), cam surface 61 includes: an upper end flat region 62 where the distance from the bottom surface of the flange portion is the largest distance; a lower end flat region 63 located at a distance from upper end flat region 62, the distance from the bottom surface of the flange portion to lower end flat region 63 being the smallest distance; and a slope portion connecting upper end flat region 62 to lower end flat region 63. Here, Fig. 3 (B) is a development view of the flange portion including cam surface 61 located annularly to surround the central portion, as seen in the lateral direction.

Bearing 44 is disposed to contact cam surface 61 of cam 43. Bearing 44 is disposed in a specific direction (on the right side of servo motor 41) as seen from cam 43 as shown in Fig. 2 (A). While the rotational shaft of servo motor 41 is rotated to rotate cam 43, bearing 44 is kept in contact with cam surface 61. Cam coupling plate 45 is connected to bearing 44. Cam coupling plate 45 has one end connected to bearing 44 and the other opposite end, and the one and the other end are fixed to movable portion 46. Application needle holder fixing portion 47 and application needle holder housing 48 are connected to movable portion 46. Application needle holder 20 is housed in application needle holder housing 48.

Application needle holder 20 includes application needle 24. Application needle 24 is disposed to protrude from the lower surface of application needle holder 20 (from the lower side opposite to the side where servo motor 41 is located). Under application needle holder 20, application material container 21 is disposed. Application needle 24 is held in the state of being inserted in application material container 21.

Movable portion 46 is provided with a fixing pin 52. A pedestal holding servo motor 41 is provided with another fixing pin 51. A spring 50 is placed to connect fixing pin 51 to fixing pin 52. On movable portion 46, a tensile force toward application material container 21 is exerted by spring 50. The tensile force exerted by spring 50 also acts on bearing 44 via movable portion 46 and cam coupling plate 45. The tensile force exerted by spring 50 causes bearing 44 to be kept pressed against cam surface 61 of cam 43.

Movable portion 46, application needle holder fixing portion 47, and application needle holder housing 48 are connected to a linear guide 49 placed on the pedestal. Linear guide 49 is disposed to extend in the Z-axis direction. Therefore, movable portion 46, application needle holder fixing portion 47, and application needle holder housing 48 are movable along the Z-axis direction.

### [Application Material Container and Application Needle]

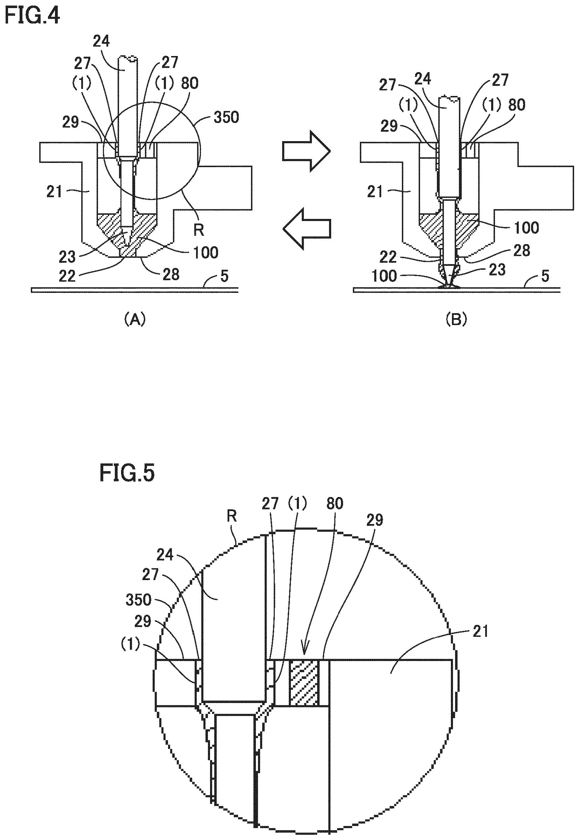

Fig. 4 shows application material container 21 and application needle 24 that are included in application unit 4 shown in Fig. 1 in Embodiment 1. Fig. 4 (A) shows an application standby state in which application needle 24 has been raised, and Fig. 4 (B) shows an application state in which application needle 24 has been lowered. Fig. 5 is an enlarged view of a region 350 shown in Fig. 4 (A).

In application material container 21, application material 100 to be used for drawing a pattern is contained. Application material 100 is a high-viscosity metal conductive material or the like. In bottom 28 of application material container 21, first hole 22 is formed. In upper lid 29, second hole 27 is formed. Further, in the present embodiment, in order to prevent generation of a pool of the application material that the conventional system suffers from, a third hole 80 is formed in upper lid 29. Air is allowed to pass between the inside and the outside of application material container 21 through third hole 80.

Application needle 24 is configured to be movable along a line passing through first hole 22 and second hole 27. By means of a linear motion mechanism of application unit 4 described later herein, head 23 of application needle 24 can be reciprocated up and down.

First hole 22 is sized to allow application needle 24 to pass through first hole 22 so that head 23 protrudes downward, and to prevent the application material held in application material container 21 from dripping downward. Second hole 27 is sized to allow application needle 24 to reciprocate up and down. Specifically, a fine gap is formed between the wall of second hole 27 and application needle 24 to enable application needle 24 to move up and down.

As application needle 24 which can reciprocate up and down is moved downward, application needle 24 protrudes from first hole 22 toward a target object to which the material is to be applied, with the application material adhering to the surface of head 23.

Referring to Fig. 4 (A), application needle 24 has been moved to the topmost end position of a movable range of application needle 24. At this time, head 23 of application needle 24 is immersed in application material 100 contained in application material container 21.

Fig. 4 (B) shows a state in which application needle 24 is lowered to cause head 23 of application needle 24 to be in contact with a target surface of substrate 5 and thereby apply application material 100 to the surface.

Referring to Fig. 4 (B), as application needle 24 is moved to the lowermost end position, head 23 passes through first hole 22 formed in the bottom of application material container 21 to protrude downward from the bottom surface of application material container 21.

As described above in connection with the background art, while the material application is repeated multiple times, the application material adheres to an upper portion of application needle 24 and also enters the gap between the upper portion of application needle 24 and the wall of second hole 27, to thereby hermetically seal upper lid 29 of application material container 21, as indicated by (1). However, when the large-diameter shaft of application needle 24 is inserted in application material container 21, air is discharged through third hole 80. Therefore, the air in application material container 21 is not pressurized and application material 100 is not pressed into first hole 22 of application material container 21. No pool of the application material is therefore generated in the present embodiment.

### [Operation of Application Unit]

An operation of above-described application unit 4 is now described. In application unit 4, servo motor 41 is driven to rotate the rotational shaft of servo motor 41 and thereby rotate cam 43. As a result, the height, in the Z-axis direction, of cam surface 61 of cam 43 is changed. Therefore, the position, in the Z-axis direction, of bearing 44 which contacts cam surface 61 on the right side of cam 43 in Fig. 2 (A) is also changed with rotation of the drive shaft of servo motor 41. With the change of the position of bearing 44 in the Z-axis direction, movable portion 46, application needle holder fixing portion 47, and application needle holder housing 48 are moved in the Z-axis direction. As a result, application needle holder 20 held by application needle holder housing 48 is also moved in the Z-axis direction. Accordingly, the position, in the Z-axis direction, of application needle 24 placed on application needle holder 20 can be changed.

Specifically, referring to Figs. 2 and 3, in the case where bearing 44 contacts upper end flat region 62 of cam surface 61 of cam 43, application needle 24 is located at its upper end position (position closest to servo motor 41) as shown in Fig. 4 (A). At this time, the head of application needle 24 is in the state of being immersed in application material 100 contained in application material container 21.

Then, in the case where the rotational shaft of servo motor 41 is rotated to rotate cam 43 and thereby cause bearing 44 to be located at a position where lower end flat region 63 of cam surface 61 contacts bearing 44, application needle 24 is in the state of passing through first hole 22 formed in the bottom of application material container 21 and protruding downward from the bottom surface of application material container 21 as shown in Fig. 4 (B). At this time, a part of application material 100 adheres to the surface of application needle 24 protruding from the bottom surface of application material container 21. Z-axis table 3 (see Fig. 1) moves application unit 4 toward substrate 5 to thereby cause the head of application needle 24 to contact the surface of substrate 5. Thus, application material 100 can be applied to the surface of substrate 5. It should be noted that Z-axis table 3 may be moved first and thereafter servo motor 41 may be driven, or Z-axis table 3 and servo motor 41 may be operated substantially simultaneously.

In this way, application unit 4 can convert the rotational motion of servo motor 41 to the motion in the Z-axis direction (up and down motion) of application needle 24. Application unit 4 configured in this way can move application needle 24 quickly and accurately in the Z-axis direction.

As seen from the above, the present embodiment enables an application material such as high-viscosity metal conductive material to be applied stably for a long time.

### [A configuration not in accordance with the invention]

### [Application Material Container and Application Needle]

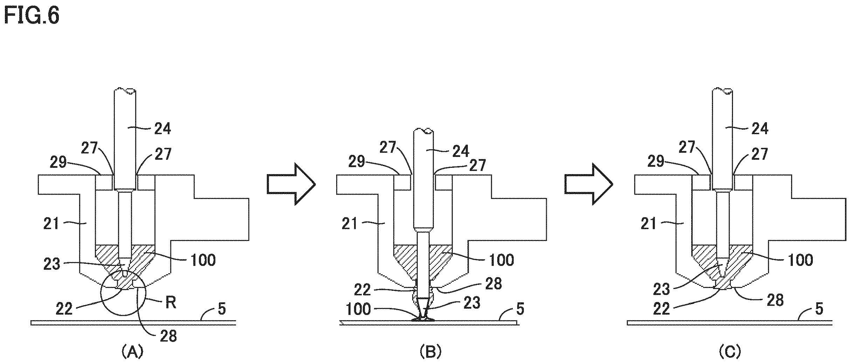

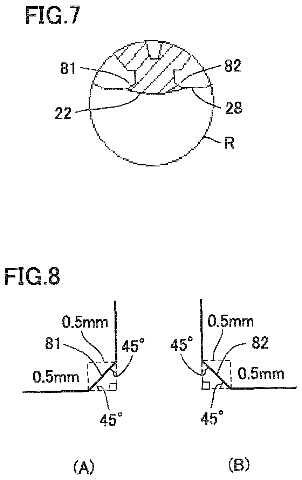

Fig. 6 shows application material container 21 and application needle 24 that are included in application unit 4 shown in Fig. 1 in a configuration not in accordance with the invention. Fig. 6 (A) and Fig. 6 (C) each show an application standby state in which application needle 24 has been raised, and Fig. 6 (B) shows an application state in which application needle 24 has been lowered. Fig. 7 is an enlarged view of a region R shown in Fig. 6 (A). Fig. 8 (A) is an enlarged view of a C chamfer 81 in Fig. 7. Fig. 8 (B) is an enlarged view of a C chamfer 82 in Fig. 7.

In application material container 21, application material 100 to be used for drawing a pattern is contained. Application material 100 is a high-viscosity metal conductive material or the like. In bottom 28 of application material container 21, first hole 22 is formed. In upper lid 29, second hole 27 is formed. The lowermost end of the wall of first hole 22 is provided with C chamfers 81, 82.

The C chamfer may be C0.5 as shown in Fig. 8 (A) and Fig. 8 (B), or smaller than C0.5.

The definition of C0.5 is specified by "JIS B0001 Technical Drawings for Mechanical Engineering 2010."

Application needle 24 is configured to be movable along a line passing through first hole 22 and second hole 27. By means of a linear motion mechanism of application unit 4 described later herein, head 23 of application needle 24 can be reciprocated up and down.

First hole 22 is sized to allow application needle 24 to pass through first hole 22 so that head 23 protrudes downward, and to prevent the application material held in application material container 21 from dripping downward. Second hole 27 is sized to allow application needle 24 to reciprocate up and down.

As application needle 24 which can reciprocate up and down is moved downward, application needle 24 protrudes from first hole 22 toward a target object to which the material is to be applied, with the application material adhering to the surface of head 23.

Referring to Fig. 6 (A), application needle 24 has been moved to the topmost end position of a movable range of application needle 24. At this time, head 23 of application needle 24 is immersed in application material 100 contained in application material container 21.

Fig. 6 (B) shows a state in which application needle 24 is lowered to cause head 23 of application needle 24 to be in contact with a target surface of substrate 5 and thereby apply application material 100 to the surface.

Referring to Fig. 6 (B), as application needle 24 is moved to the lowermost end position, head 23 passes through first hole 22 formed in the bottom of application material container 21 to protrude downward from the bottom surface of application material container 21.

In the present configuration, a pool of the application material as described above in connection with the background art will not be generated even after application is repeated multiple times.

This is for the following reason. Because C chamfers 81, 82 are formed, the application material flowing downward from the lower end of first hole 22 of application material container 21 together with head 23 of application needle 24 returns smoothly into application material container 21 together with head 23 of application needle 24. The application material is therefore prevented from accumulating on the lower end of first hole 22.

### [Operation of Application Unit]

An operation of above-described application unit 4 is now explained. In application unit 4, servo motor 41 is driven to rotate the rotational shaft of servo motor 41 and thereby rotate cam 43. Accordingly, cam surface 61 of cam 43 changes in the Z-axis height, and therefore, the Z-axis position of bearing 44 that is in contact with a right portion of cam surface 61 of cam 43 in Fig. 2 (A) also changes with rotation of the drive shaft of servo motor 41. As the Z-axis position of bearing 44 changes, movable portion 46, application needle holder fixing portion 47, and application needle holder housing 48 move in the Z-axis direction. Accordingly, application needle holder 20 held by application needle holder housing 48 also moves in the Z-axis direction. Thus, the Z-axis position of application needle 24 mounted on application needle holder 20 can be changed.

Specifically, referring to Figs. 2 and 3, when bearing 44 is in contact with upper end flat region 62 of cam surface 61 of cam 43, application needle 24 is located at its uppermost end position (position closest to servo motor 41) as shown in Fig. 6 (A).

At this time, the head of application needle 24 is immersed in application material 100 held in application material container 21.

Next, when the rotational shaft of servo motor 41 rotates to cause cam 43 to rotate and thereby cause bearing 44 to reach the position where lower end flat region 63 of cam surface 61 is in contact with bearing 44, application needle 24 is in the state of passing through first hole 22 formed in the bottom of application material container 21 to protrude downward from the bottom surface of application material container 21 as shown in Fig. 6 (B). At this time, a part of application material 100 adheres to the surface of application needle 24 protruding from the bottom surface of application material container 21. Then, Z-axis table 3 (see Fig. 1) moves application unit 4 toward substrate 5 to cause the head of application needle 24 to be in contact with the surface of substrate 5, to thereby enable application material 100 to be applied to the surface of substrate 5. Z-axis table 3 may be moved first and thereafter servo motor 41 may be driven, or Z-axis table 3 and servo motor 41 may be operated substantially at the same time.

In this way, application unit 4 can convert the rotational motion of servo motor 41 to the motion in the Z-axis direction (up and down motion) of application needle 24. Application unit 4 configured in this way can move application needle 24 quickly and accurately in the Z-axis direction.

As seen from the above, the present configuration enables an application material such as high-viscosity metal conductive material to be applied stably for a long time. Consequently, it is possible to stably draw a circuit such as RFID by means of the application needle system.

The above-described configuration of the application apparatus is given by way of example. The application apparatus is not limited to the above configuration but may at least be configured to be capable of applying a material to a given position on a target surface of a target substrate to which the material is to be applied.

For example, the C chamfers formed at the lowermost end of the wall of the first hole are not limited to C0.5. Alternatively, the C chamfers may be C0.5 or less or may have another size. Further, the chamfer angle may be any angle other than 45°.

It should be construed that embodiments disclosed herein are given by way of illustration in all respects, not by way of limitation. It is intended that the scope of the present invention is defined by claims.

### INDUSTRIAL APPLICABILITY

The present invention is applied particularly advantageously to an application unit, an application apparatus, a method for manufacturing an object to which a material is applied, and a method for manufacturing a substrate, for drawing an electrically conductive pattern, repairing open defects in an electrically conductive pattern, forming a fine circuit pattern such as RFID tag, repairing defects in such a circuit pattern, or applying an electrically conductive adhesive.

### REFERENCE SIGNS LIST

4 application unit; 5 substrate; 6 observation optical system; 7 camera; 8 operation panel; 9 monitor; 10 control computer; 11 control unit; 12 base; 21, 121 application material container; 22 first hole; 23 head; 24 application needle; 27 second hole; 28, 128 bottom; 29, 129 upper lid; 41 servo motor; 43 cam; 44 bearing; 45 cam coupling plate; 46 movable portion; 47 application needle holder fixing portion; 48 application needle holder housing; 49 linear guide; 50 spring; 51, 52 fixing pin; 61 cam surface; 62 upper end flat region; 63 lower end flat region; 80 third hole; 81, 82 C chamfer; 100 application material; 200 application apparatus

## Claims

1. An application unit (4) comprising:
a container (21) to contain an application material (100); and
an application needle (24) to apply, to a target surface, the application material (100) contained in the container (21),
a first hole (22) being formed in a bottom (28) of the container (21), a second hole (27) being formed in an upper lid (29) of the container (21),
the application needle (24) being configured to be movable along a line passing through the first hole (22) and the second hole (27),
**characterized in that**
said application needle (24) comprising an upper part having a large diameter shaft arranged to be inserted into the application material container,
a fine gap is formed between the wall of second hole (27) and application needle (24) to enable the application needle (24) to move up and down,
a third hole (80) being formed in a part of the container (21) for allowing air to be discharged through the third hole (80) when the large-diameter shaft of the application needle (24) is inserted in the application material container (21), and allowing the air in application material container (21) not to be pressurized when the application material (100) adheres to an upper portion of application needle (24) and also enters the fine gap between the upper portion of application needle (24) and the wall of second hole (27) and thereby hermetically seals upper lid (29) of application material container (21).

2. The application unit (4) according to claim 1, wherein the third hole (80) is formed in the upper lid (29).

3. An application apparatus (200) for applying the application material (100) to the target surface using an application unit (4) according to any one of claims 1 or 2.

4. A method for manufacturing an object to which a material (100) is applied using any of an application unit (4) according to any one of claims 1 or 2 and an application apparatus (200) according to claim 3.

## Patentansprüche

1. Aufbringungseinheit (4), umfassend:
einen Behälter (21) zum Enthalten eines Aufbringungsmaterials (100); und
eine Aufbringungsnadel (24) zum Aufbringen des in dem Behälter (21) enthaltenen Aufbringungsmaterials (100) auf eine Zielfläche,
ein erstes Loch (22), das in einem Boden (28) des Behälters (21) ausgebildet ist, und ein zweites Loch (27), das in einem oberen Deckel (29) des Behälters (21) ausgebildet ist,
wobei die Aufbringungsnadel (24) dafür konfiguriert ist, entlang einer Linie beweglich zu sein, die durch das erste Loch (22) und das zweite Loch (27) hindurch verläuft,
**dadurch gekennzeichnet, dass**
wobei die Aufbringungsnadel (24) einen oberen Teil umfasst, der einen Schaft mit großem Durchmesser aufweist, der dafür ausgelegt ist, in den Aufbringungsmaterialbehälter eingeführt zu werden,
ein feiner Spalt zwischen der Wand des zweiten Lochs (27) und der Aufbringungsnadel (24) ausgebildet ist, damit sich die Aufbringungsnadel (24) auf und ab bewegen kann,
ein drittes Loch (80), das in einem Teil des Behälters (21) ausgebildet ist, damit Luft durch das dritte Loch (80) hindurch abgelassen werden kann, wenn der Schaft mit großem Durchmesser der Aufbringungsnadel (24) in den Aufbringungsmaterialbehälter (21) eingeführt wird, und damit die Luft in dem Aufbringungsmaterialbehälter (21) nicht unter Druck gesetzt wird, wenn das Aufbringungsmaterial (100) an einem oberen Abschnitt der Aufbringungsnadel (24) haftet und auch in den feinen Spalt zwischen dem oberen Abschnitt der Aufbringungsnadel (24) und der Wand des zweiten Lochs (27) eintritt und dadurch den oberen Deckel (29) des Aufbringungsmaterialbehälters (21) hermetisch abdichtet.

2. Aufbringungseinheit (4) nach Anspruch 1, wobei das dritte Loch (80) in dem oberen Deckel (29) ausgebildet ist.

3. Aufbringungsvorrichtung (200) zum Aufbringen des Aufbringungsmaterials (100) auf die Zielfläche unter Verwendung einer Aufbringungseinheit (4) nach einem der Ansprüche 1 und 2.

4. Verfahren zum Herstellen eines Gegenstandes, auf den ein Material (100) unter Verwendung einer Aufbringungseinheit (4) nach einem der Ansprüche 1 und 2 und einer Aufbringungsvorrichtung (200) nach Anspruch 3 aufgebracht wird.

## Revendications

1. Unité d'application (4) comprenant :
un récipient (21) pour contenir un matériau d'application (100) ; et
une aiguille d'application (24) pour appliquer, sur une surface cible, le matériau d'application (100) contenu dans le récipient (21),
un premier orifice (22) étant formé dans un fond (28) du récipient (21), un deuxième orifice (27) étant formé dans un couvercle supérieur (29) du récipient (21),
l'aiguille d'application (24) étant configurée pour être mobile le long d'une ligne passant à travers le premier orifice (22) et le deuxième orifice (27), **caractérisée en ce que** ladite aiguille d'application (24) comprend une partie supérieure ayant une tige de grand diamètre agencée pour être insérée dans le récipient de matériau d'application,
un espace mince est formé entre la paroi du deuxième orifice (27) et l'aiguille d'application (24) pour permettre à l'aiguille d'application (24) de se déplacer vers le haut et le bas,
un troisième orifice (80) est formé dans une partie du récipient (21) pour permettre à l'air d'être évacué à travers le troisième orifice (80) lorsque la tige de grand diamètre de l'aiguille d'application (24) est insérée dans le récipient de matériau d'application (21), et permettre à l'air dans le récipient de matériau d'application (21) de ne pas être mis sous pression lorsque le matériau d'application (100) adhère à une portion supérieure de l'aiguille d'application (24) et entre alors dans le mince espace entre la portion supérieure de l'aiguille d'application (24) et la paroi du deuxième orifice (27) pour ainsi rendre étanche hermétiquement le couvercle supérieur (29) du récipient de matériau d'application (21).

2. Unité d'application (4) selon la revendication 1, dans laquelle le troisième orifice (80) est formé dans le couvercle supérieur (29).

3. Appareil d'application (200) destiné à appliquer le matériau d'application (100) sur la surface cible à l'aide d'une unité d'application (4) selon l'une quelconque des revendications 1 ou 2.

4. Procédé destiné à fabriquer un objet sur lequel un matériau (100) est appliqué à l'aide d'un quelconque moyen parmi une unité d'application (4) selon une quelconque des revendications 1 ou 2 et un appareil d'application (200) selon la revendication 3.
